# EUROPEAN PATENT SPECIFICATION

(11) **EP 0 776 026 B1**
(45) Date of publication and mention of the grant of the patent: **31.10.2001**
(21) Application number: 96304288.2
(22) Date of filing: 07.06.1996
(51) Int. Cl.: H01L 21/00

(54) **Semiconductor device manufacturing apparatus employing vacuum system**
Gerät zur Herstellung einer Halbleitervorrichtung mit Vakuumsystem
Appareil de fabrication d'un dispositif semi-conducteur utilisant un système à vide

(30) Priority: 21.11.1995 KR 9542623
(43) Date of publication of application: 28.05.1997
(60) Divisional application: 00302162.3
(73) Proprietor: SAMSUNG ELECTRONICS CO., LTD., Suwon-City, Kyungki-do (KR)
(72) Inventor: Jeon, Jae-sun, Suwon-city, Kyungki-do (KR); Yang, Yun-mo, Seocho-gu, Seoul (KR); Kim, Won-yeong, Kiheung-eub Yongin-city, Kyungki-do (KR); Chae, Seung-ki, Yangcheon-gu, Seoul (KR)
(74) Representative: Ertl, Nicholas Justin

(56) References cited:
- EP-A- 0 385 709
- EP-A- 0 666 339
- US-A- 4 739 787
- US-A- 5 308 989
- US-A- 5 314 541

## Description

The present invention relates to a semiconductor device manufacturing apparatus, and, more particularly, to a semiconductor device manufacturing apparatus employing a vacuum system.

In semiconductor device fabrication using a semiconductor device manufacturing apparatus employing a vacuum system, particles are formed during the pressure-reduction (pump down) of a process chamber and the formed particles settle on wafers being processed. Such particulate contamination of a semiconductor wafer significantly lowers the product yield and reliability of a semiconductor device. This problem becomes more severe with increasing wafer diameters and higher integration levels.

Particle formation during pressure-reduction or venting is attributed to a condensation mechanism caused by adiabatic expansion of gas (see "Condensation-Induced Particle Formation during Vacuum Pump Down" by Yan Ye et al., *Journal of the Electrochemical Society,* Vol. 140, No. 5, pp. 1463-1468, May 1993). According to the suggested mechanism, on a rapid drop in the pressure of a process chamber, gas in the chamber undergoes adiabatic expansion and its temperature falls rapidly. The gas is simultaneously condensed into water droplets. During the droplet formation, gases in the air such as SO₂, O₃, H₂O and other gaseous impurities diffuse into the droplets and are thus absorbed. Then, as the thermal capacity of the chamber walls is greater than that of the droplets, the inner surface temperature of the chamber decreases more slowly than that of the droplets. The resulting temperature difference causes heat to be transferred from the chamber to the droplets, leading to the heating and evaporation of the droplets, so that the concentration of impurities in the liquid increases. During the concentrated liquid phase, when the concentration of H₂O₂ in the liquid reaches a high enough level, H₂O₂ reacts quickly with SO₂ to form sulfuric acid, leading to the formation of sulfuric acid droplets. As the droplets continue to evaporate, residue particles which are spherical in shape are formed and which contain mainly sulfuric acid. The main elemental components of the residue particles are carbon, sulfur and oxygen, and the residue particles are quite stable thermodynamically.

The residue particles thus do not evaporate completely even upon heating to temperatures as high as 180°C.

If the process chamber is smaller, the relative humidity of gas is higher and/or a depressurizing speed or a venting speed is higher, more condensation-induced particles are found.

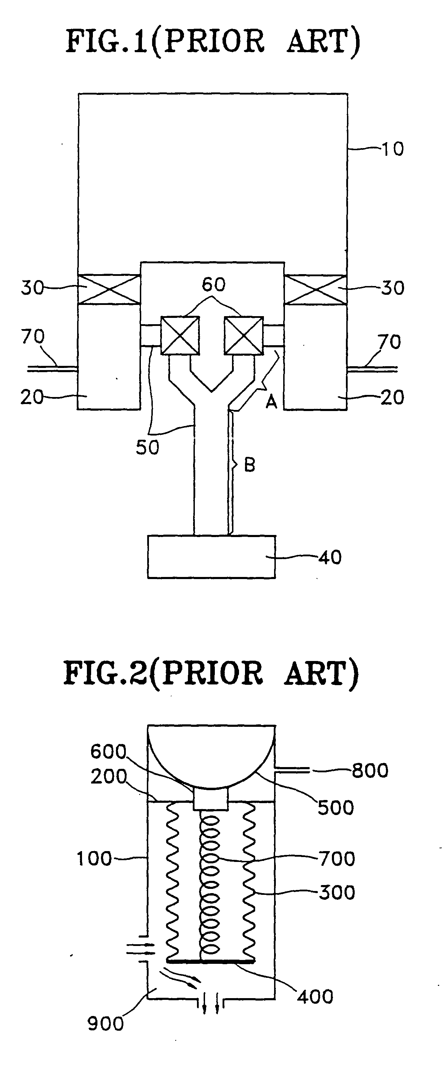

FIG. 1 is a schematic view of an ion-implanting apparatus in a conventional semiconductor device manufacturing apparatus known to the applicant employing a vacuum system. Here, a reference numeral 10 denotes a process chamber for ion-implanting a semiconductor wafer therein; reference numeral 20 denotes two load lock chambers, communicating with predetermined portions of the process chamber 10, for loading wafers to be transferred to the process chamber; reference numeral 30 denotes isolation valves installed between the process chamber 10 and each of the load lock chambers 20, for determining isolation of the process chamber 10 from the load lock chambers 20; reference numeral 40 denotes a pump for reducing the pressure of the load lock chambers 20 to transfer the wafers to the process chamber 10 in vacuum; reference numeral 50 denotes an exhaust pipe having two sub-pipes A connected to the respective load lock chambers 20 and a main pipe B of which one end is connected to the sub-pipes A and the other end is connected to the pump 40; and reference numeral 60 denotes shut-off valves installed in a predetermined portion of the sub-pipes A, for determining shut-off of the flow of gas from the load lock chambers 20 to pump 40.

In the device of FIG. 1, an air valve, which is opened and closed depending on gas pressure, is usually used as the shut-off valve 60. The diameter of the main pipe B is larger than that of the sub-pipes A, since gas flowing from the load lock chambers 20 is collected in and passes through the main pipe B. Also, reference numeral 70 denotes an inlet for injecting venting-gas into the load lock chambers 20.

The operation of the conventional semiconductor device manufacturing apparatus employing a vacuum system will now be described with reference to FIG. 1.

The exhaust pipe 50 installed between the shut-off valves 60 and pump 40 is maintained in a low vacuum of about 10⁻³Torr. Wafers are then loaded in the load lock chambers 20, and the shut-off valves 60 are opened to drop the pressure of the load lock chambers 20 to about 10⁻³ Torr. Thereafter, the wafers are transferred to the process chamber 10 by opening the isolation valves 30. Here, the process chamber 10 is at a high vacuum of about 10⁻⁶Torr.

The load lock chambers 20 are set to the lower vacuum so that a sudden turbulence of gas is prevented, and particles are preliminarily reduced before the wafers are transferred to the process chamber 10 by reducing the difference between the high vacuum of the process chamber 10 and the atmospheric pressure of the load lock chambers 20.

FIG. 2 is a sectional magnified view of the air valve 60 used as a shut-off valve. Here, a reference numeral 100 is a cylindrical case having orifices on the side and base thereof; reference numeral 200 denotes a board installed in a predetermined portion inside the case 100 to divide it into an upper part and a lower part and having a hole for communicating the lower part with the upper part in the center thereof; reference numeral 300 denotes a bellows fixed to the board 200 around the hole thereof to be sealed by the lower surface of the board and having an O-ring on the lower end portion thereof to open and close the base orifice of the case 100; reference numeral 500 denotes an elastic rubber boot installed on the internal upper surface of the case 100 and convex toward the lower part of the case 100; reference numeral 600 denotes a spring support fixed to the convex surface of the rubber boot 500, one portion thereof being inserted into the hole of the board 200; reference numeral 700 denotes a spring, one end of which is fixed to the base of the bellows 300 and whose other end is fixed to the spring support 600; reference numeral 800 denotes an air inlet communicating with a side of the upper part of the case 100, formed by the board 200; and reference numeral 900 denotes the flow of gas from the load lock chambers 20 to the pump 40 (FIG.1). If the pressure of air injected through the air inlet 800 is below a predetermined value, the lower orifice of the case 100 is closed by the bellows 400. If the air pressure is greater than or equal to the predetermined pressure, the convex end portion of the rubber boot 500 is pushed upward, vertically contracting the bellows 400 and thus opening the lower orifice of the case 100. Since the lower orifice is quickly opened, the pressure of the load lock chambers 20 also rapidly drops.

FIG. 3 shows scanning electron microspectroscopy (SEM) photographs of particles formed in the load lock chambers 20. The particles are about 0.3-3.7*µ*m in diameter and spherical in shape.

FIG. 4 illustrates the result obtained by analyzing the components of the particles of FIG. 3 by Auger electron spectroscopy (AES). Here, the main components are shown to be sulfur, oxygen and carbon.

As described above, in the conventional semiconductor device manufacturing apparatus employing a vacuum system, gas condensation is found to be the cause of particle formation in an analysis of the shape and components of particles generated in the load lock chambers, as suggested by Yan Ye et al. In other words, as the shut-off valves installed on the exhaust pipe for exhausting the load lock chambers of gas are rapidly opened, the pressure of the load lock chambers drops quickly. Therefore, particle formation is attributed to adiabatic expansion of the gas in the load lock chambers.

By the same mechanism as above, the adiabatic expansion of venting-gas produces particles during the venting of the load lock chambers.

European Patent Application Number 0,385,709 discloses a fluid flow control method and apparatus for minimising particle contamination. The fluid flow is controlled to ensure that the flow rates are maintained at values which are not high enough to dislodge particulate contaminants from the chamber walls of the apparatus. European Patent Application Number 0,666,339 discloses a method of in-situ cleaning a throttle valve in a chemical vapour deposition device and an exhaust flow control apparatus for facilitating such cleaning. The cleaning is performed using a plasma which is ignited in a cleaning gas mixture of nitrogen triflouride, hexaflouroethane and oxygen.

The object of the present invention is to provide a semiconductor device manufacturing apparatus which can reduce condensation-induced particle formation by preventing adiabatic expansion of gas in a load lock chamber.

According to the present invention, there is provided a semiconductor device manufacturing apparatus comprising:
a process chamber for fabricating a semiconductor device therein;
a load lock chamber communicating with a predetermined portion of said process chamber, for loading of a semiconductor wafer to be transferred to said process chamber;
a pump for reducing the pressure of said load lock chamber;
a venting pipe connecting said load lock chamber with said pump, for venting gas from said load lock chamber; and
one or more valves installed in a predetermined portion of said venting pipe,
wherein said valve or valves are venting speed controlling valves for controlling the speed of gas flowing from said load lock chamber to said pump, and
wherein said load lock chamber comprises a venting-gas inlet for injecting venting gas into said load lock chamber, and a heating source installed in a predetermined portion of said venting-gas inlet.

An example of the present invention will now described in detail below, with reference to the accompanying drawings, in which:
FIG. 1 is a schematic view of a conventional semiconductor device manufacturing apparatus employing a vacuum system;
FIG. 2 is a sectional view of an air valve used as a shut-off valve of FIG. 1;

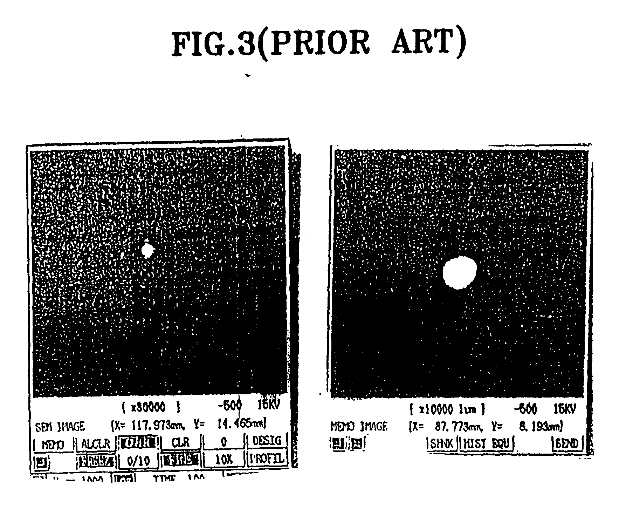

FIG. 3 shows SEM photographs of particles generated in the load lock chambers of FIG. 1;

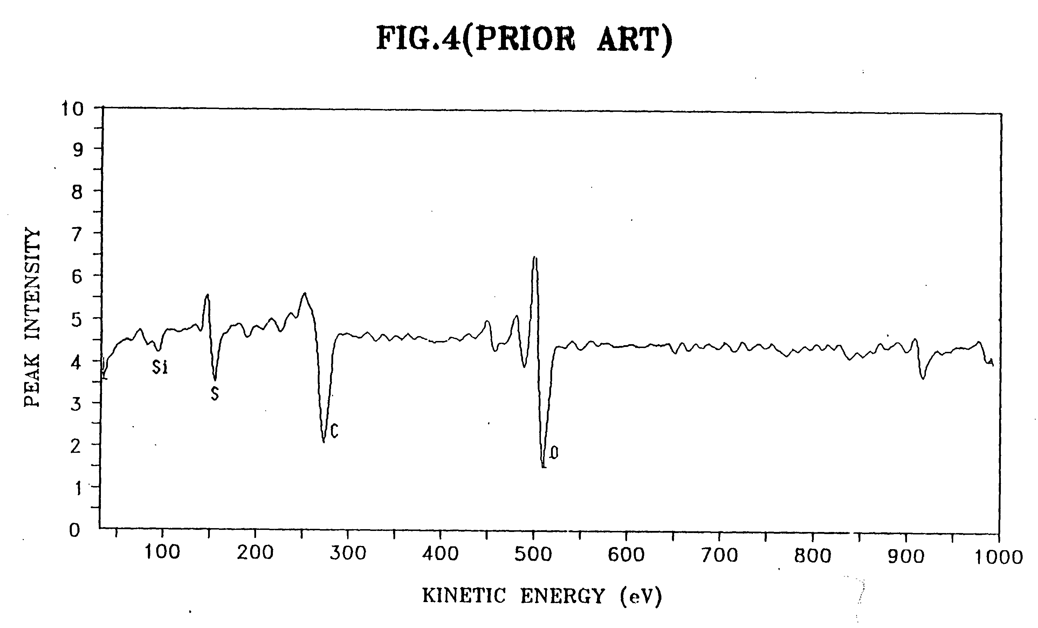

FIG. 4 shows the result from an AES analysis of the components of the particles of FIG. 3;

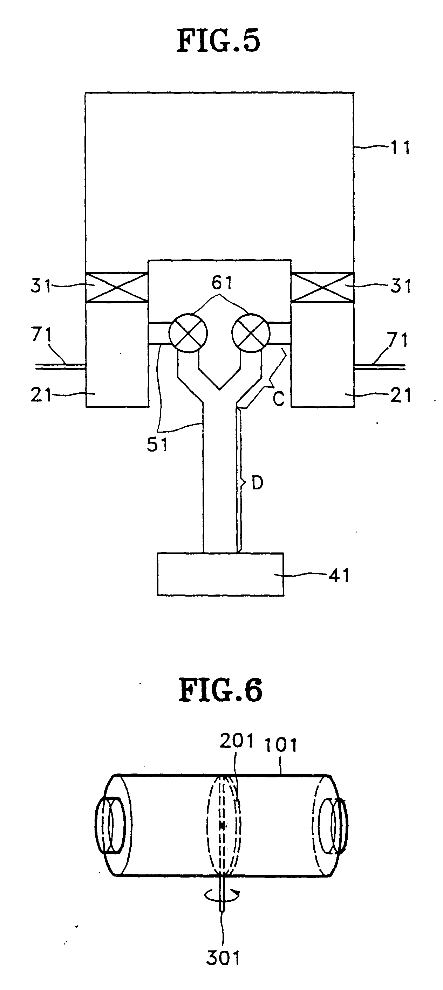

FIG. 5 is a schematic view of a semiconductor device manufacturing apparatus according to the present invention;
FIG. 6 is a schematic view of a throttle valve used as a venting speed controlling valve shown in FIG. 5;

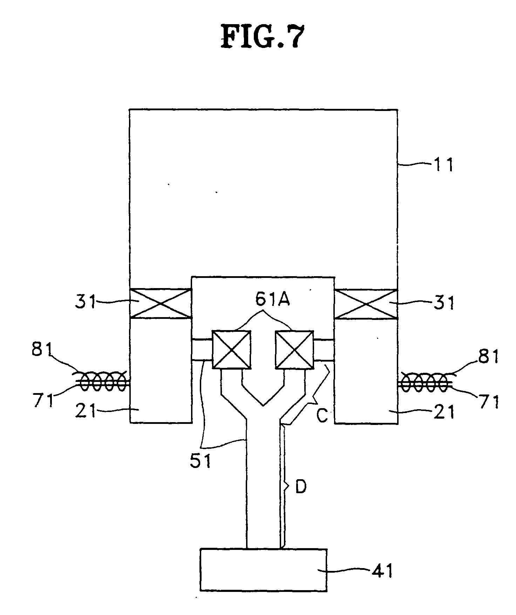

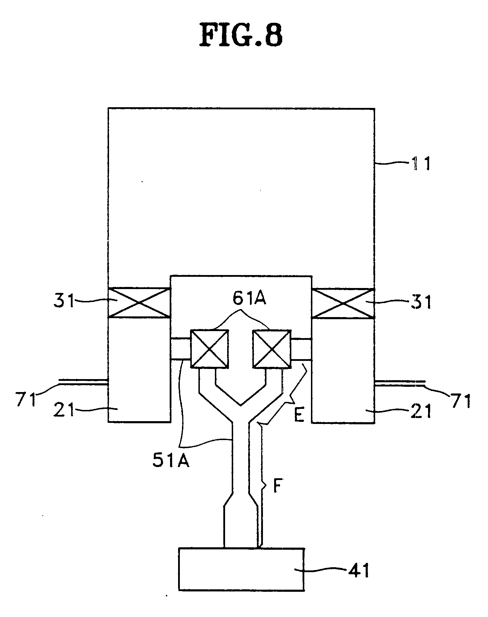

FIG. 7 is a schematic view of a second example of a semiconductor device manufacturing apparatus according to the present invention.

FIG. 5 is a schematic view of a semiconductor device manufacturing apparatus, in particular an ion-implanting device, according to a first embodiment of the present invention. Here, a reference numeral 11 denotes a process chamber for ion-implanting a semiconductor wafer therein; reference numeral 21 denotes a plurality of, for example two, load lock chambers communicating with predetermined portions of the process chamber 11 for loading semiconductor wafers to be transferred to the process chamber; reference numeral 31 denotes isolation valves disposed between the process chamber 11 and each load lock chamber 21 of the process chamber 11 from the load lock chambers 21; reference numeral 41 denotes a pump for reducing the pressure of the load lock chambers 21 to enable transfer of the wafers from the load lock chambers 21 to the process chamber 11 in vacuum; reference numeral 51 denotes a venting pipe having a plurality (e.g., two) of sub-pipes C, each sub-pipe being connected to each load lock chamber 21, and a main pipe D, one end of which is connected to the sub-pipes C and whose other end is connected to pump 41; reference numeral 61 denotes a venting speed controlling valve installed to the venting pipe 51, for controlling the speed of the flow of gas from the load lock chambers 21 to the pump 41 by controlling the opening thereof; and reference numeral 71 denotes a venting-gas inlet for injecting venting-gas into each load lock chamber 21.

Preferably, the diameter of main pipe D is larger than that of the sub-pipes C, since gas flowing from the load lock chambers 21 is collected in and pass through the main pipe D. Further, a throttle valve may be used as the venting speed controlling valve 61.

According to the embodiment, condensation-induced particle formation can be reduced by steadily increasing a venting speed with the venting speed controlling valve 61, and thus preventing adiabatic expansion of gas caused by a rapid drop of pressure of the load lock chambers 21. In addition, condensation-induced particle formation can also be reduced by providing a heating source, for example, a heater line 81 in a predetermined portion of the venting gas inlet, to heat up gas injected during a venting process and thus reduce its relative humidity.

FIG. 6 is a schematic view of a throttle valve used as the venting-speed controlling valve 61. Here, a reference numeral 101 denotes a cylindrical case having orifices in the sides thereof through which the cylindrical case 101 is connected to the venting pipe 51 of FIG. 5; reference numeral 201 denotes a disk-shaped rotational plate for dividing case 101 into left and right parts; and reference numeral 301 denotes a rotational shaft being rotated by a motor (not shown) and combined with the rotational plate 201 to vertically penetrate through the case 101 and pass through the center of the rotational plate 201. Thus, the rotational plate 201 is rotated by the rotation of the rotational shaft 301 with the rotational shaft as an axis, and the speed of gas flowing from the load lock chambers 21 to pump 41 (FIG. 5) depends on the degree of rotation.

FIG. 7 is a schematic view of a semiconductor device manufacturing apparatus, in particular an ion-implanting device, according to a second embodiment of the present invention. Like reference numerals denote the same elements as in FIG. 5. Reference numeral 61A denotes a shut-off valve installed in a predetermined portion of the sub-pipe C for shut-off of the flow of gas from the load lock chambers 21 to the pump 41. An air valve, for example, can be used as a shut-off valve. A reference numeral 81 denotes a heating source installed in a predetermined portion of the venting-gas inlet 71. A heating line, for example, can be used as the heating source. The heating source 81 heats up venting gas injected into the load lock chambers 21 to decrease the relative humidity of the venting gas, thereby reducing condensation-induced particle formation in the load lock chambers 21.

As described above, according to the preferred embodiments of the present invention, condensation-induced particle formation can be reduced by preventing adiabatic expansion of gas.

## Claims

1. A semiconductor device manufacturing apparatus comprising:
a process chamber (11) for fabricating a semiconductor device therein;
a load lock chamber (21) communicating with a predetermined portion of said process chamber, for loading of a semiconductor wafer to be transferred to said process chamber (11);
a pump (41) for reducing the pressure of said load lock chamber (21);
a venting pipe (51) connecting said load lock chamber (21) with said pump (41), for venting gas from said load lock chamber (21); and
one or more valves (61) installed in a predetermined portion of said venting pipe,
wherein said valve or valves (61) are venting speed controlling valves for controlling the speed of gas flowing from said load lock chamber (21) to said pump (41), and wherein said load lock chamber (21) comprises a venting-gas inlet (71) for injecting venting gas into said load lock chamber (21), and a heating source (81) installed in a predetermined portion of said venting-gas inlet (71).

2. A semiconductor device manufacturing apparatus as claimed in claim 1, wherein said venting speed controlling valve or valves (61) are throttle valves.

3. A semiconductor device manufacturing apparatus as claimed in claim 2, wherein said throttle valve or valves (61) comprise:
a cylindrical case (101) having orifices formed in both sides thereof for connection to said venting pipe (51);
a disk-shaped rotational plate (201) for dividing said case (101) into left and right parts;
a rotational shaft (301) combined with said rotational plate (201) to penetrate vertically through said case (101) and pass through the center of said rotational plate (201) ; and
a force source for transferring force to said rotational shaft.

4. A semiconductor device manufacturing apparatus as claimed in claim 3, wherein said force source is a motor.

5. A semiconductor device manufacturing apparatus as claimed in claim 1, wherein said heating source (81) is a heater line surrounding said venting-gas inlet (71).

## Patentansprüche

1. Gerät zur Herstellung einer Halbleitervorrichtung umfassend:
eine Prozesskammer (11) zur Fertigung einer Halbleitervorrichtung darin,
eine Ladeschleusenkammer (21), die mit einem bestimmten Teil der Prozesskammer in Verbindung steht, zum Laden eines Halbleiterwafers, der in die Prozesskammer (11) zu überführen ist,
eine Pumpe (41) zum Reduzieren des Druckes in der Ladeschleusenkammer (21), ein Lüftungsrohr (51), das die Ladeschleusenkammer (21) mit der Pumpe (41) verbindet, um Gas aus der Ladeschleusenkammer (21) zu entlüften, und
eines oder mehrere Ventile (61), die in einem bestimmten Teil des Lüftungsrohrs installiert sind,
worin das Ventil oder die Ventile (61) die Lüftungsgeschwindigkeit steuernde Ventile sind, um die Geschwindigkeit des aus der Ladeschleusenkammer (21) zur Pumpe (41) strömenden Gases zu steuern, und worin die Ladeschleusenkammer (21) einen Belüftungsgaseinlass (71) zum Einleiten von Lüftungsgas in die Ladeschleusenkammer (21) aufweist und eine in einem bestimmten Teil des Belüftungsgaseinlasses (71) installierte Wärmequelle (81).

2. Gerät zur Herstellung einer Halbleitervorrichtung nach Anspruch 1, worin das die Lüftungsgeschwindigkeit steuernde Ventil oder die Ventile (61) Drosselventile sind.

3. Gerät zur Herstellung einer Halbleitervorrichtung nach Anspruch 2, worin das Drosselventil oder die Drosselventile (61) umfassen:
ein zylindrisches Gehäuse (101) mit in seinen beiden Seiten ausgebildeten Öffnungen zur Verbindung mit dem Lüftungsrohr (51),
eine scheibenförmige Drehplatte (201) zum Unterteilen des Gehäuses (101) in einen linken und rechten Teil,
eine mit der Drehplatte (201) kombinierte Rotationswelle (301), die das Gehäuse (101) vertikal durchdringt und durch die Mitte der Drehplatte (201) verläuft, und
eine Kraftquelle zum Übertragen von Kraft auf die Rotationswelle.

4. Gerät zur Herstellung einer Halbleitervorrichtung nach Anspruch 3, worin die Kraftquelle ein Motor ist.

5. Gerät zur Herstellung einer Halbleitervorrichtung nach Anspruch 1, worin die Wärmequelle (81) eine Heizungsleitung ist, die den Lüftungsgaseinlass (71) umgibt.

## Revendications

1. Appareil de fabrication de dispositif semi-conducteur comprenant :
une chambre de traitement (11) pour fabriquer un dispositif semi-conducteur à l'intérieur ;
un sas de chargement (21) communiquant avec une portion prédéterminée de ladite chambre de traitement, pour le chargement d'une tranche de semi-conducteur à transférer dans ladite chambre de traitement (11) ;
une pompe (41) pour réduire la pression dudit sas de chargement (21) ;
une canalisation de pompage (51) reliant ledit sas de chargement (21) avec ladite pompe (41), pour pomper le gaz dudit sas de chargement (21), et
une ou plusieurs vannes (61) installées dans une portion prédéterminée de ladite canalisation de pompage,
dans lequel ladite vanne ou vannes (61) sont des vannes contrôlant la vitesse de pompage pour contrôler la vitesse d'écoulement de gaz dudit sas de chargement (21) à ladite pompe (41), et dans laquelle ledit sas de chargement (21) comprend une introduction de gaz de pompage (71) pour injecter du gaz de pompage dans ledit sas de chargement (21), et une source de chauffage (81) installée dans une portion prédéterminée de ladite introduction du gaz de pompage (71).

2. Appareil de fabrication de dispositif semi-conducteur tel que revendiqué à la revendication 1, dans lequel ladite vanne ou vannes (61) contrôlant la vitesse de pompage sont des vannes à étranglement.

3. Appareil de fabrication de dispositif semi-conducteur tel que revendiqué à la revendication 2, dans lequel ladite vanne à étranglement ou vannes (61) comprend :
un boîtier cylindrique (101) ayant des orifices formés des deux côtés de celle-ci pour le relier à ladite canalisation de pompage (51) ;
une plaque en rotation en forme de disque (201) pour diviser ledit boîtier (101) en parties gauche et droite ;
un arbre en rotation (301) combiné avec ladite plaque en rotation (201) pour pénétrer verticalement à travers ledit boîtier (101) et passer à travers le centre de ladite plaque en rotation (201) ; et
une source de force pour communiquer une force audit arbre en rotation.

4. Appareil de fabrication de dispositif semi-conducteur tel que revendiqué à la revendication 3, dans lequel ladite source de force est un moteur.

5. Appareil de fabrication de dispositif semi-conducteur tel que revendiqué à la revendication 1, dans lequel ladite source de chauffage (81) est une canalisation chauffante entourant ladite introduction de gaz de pompage (71).
